# EUROPÄISCHE PATENTSCHRIFT

(11) **EP 2 433 317 B1**
(45) Veröffentlichungstag und Bekanntmachung des Hinweises auf die Patenterteilung: **30.07.2014**
(21) Anmeldenummer: 10732264.6
(22) Anmeldetag: 19.05.2010
(51) Int. Cl.: H01L 51/42, H01L 51/46, C07F 3/06

(54) **HALBLEITENDES BAUELEMENT**
SEMICONDUCTING COMPONENT
COMPOSANT SEMI-CONDUCTEUR

(30) Priorität: 19.05.2009 DE 102009021881; 19.05.2009 DE 102009021882
(43) Veröffentlichungstag der Anmeldung: 28.03.2012
(73) Patentinhaber: heliatek GmbH, 01139 Dresden (DE); BASF SE, 67056 Ludwigshafen (DE)
(72) Erfinder: GRESSER, Roland, 68239 Mannheim (DE); MÜLLER, Toni, 01159 Dresden (DE); HUMMERT, Markus, 01309 Dresden (DE); RIEDE, Moritz, 01099 Dresden (DE); HARTMANN, Horst, 01326 Dresden (DE); LEO, Karl, 01219 Dresden (DE)
(74) Vertreter: Bittner, Thomas L.
(86) Internationale Anmeldenummer: PCT/DE2010/000552
(87) Internationale Veröffentlichungsnummer: WO 2010/133208

(56) Entgegenhaltungen:
- BREDERECK, H: "Über 1-[3-Aryl-isoindolyl-(1)-imino]-3-aryl-1H- isoindole" CHEMISCHE BERICHTE, Bd. 105, Juli 1972 (1972-07), Seiten 2271-2283, XP002599116
- DONYAGINA V F ET AL: "Synthesis of N,N-difluoroboryl complexes of 3,3'-diarylazadiisoindoly lmethenes" TETRAHEDRON LETTERS, ELSEVIER, AMSTERDAM, NL LNKD- DOI:10.1016/J.TETLET.2008.08.026, Bd. 49, Nr. 42, 13. Oktober 2008 (2008-10-13), Seiten 6152-6154, XP024528704 ISSN: 0040-4039 [gefunden am 2008-08-27]

## Beschreibung

Die vorliegende Erfindung betrifft ein halbleitendes Bauelement, das mehrere Schichten umfasst. Eine oder mehrere Schichten können dabei Verbindungen umfassen, die als Lichtabsorber, Ladungstränsportmaterial und/oder Dotand wirken können.

In den letzten Jahren erlangten organische Verbindungen mit intensiven Absorptionen im roten und infraroten Spektralbereich wegen ihrer Einsetzbarkeit in zahlreichen Gebieten von Wissenschaft und Technik ein besonderes Interesse. So können solche Verbindungen als aktive Medien in lasergetriebenen Aufzeichnungsmedien, wie CD oder DVD, oder in Solarzellen zur Umwandlung von Wärmestrahlung in elektrische Energie sowie in Wärmedämmmaterialen zur Vermeidung von Aufheizungen im Inneren geschlossener Räume, wie in Fahrzeugen oder Schaufensterbereichen, eingesetzt werden. Dabei müssen solche langwellig absorbierenden Verbindungen zudem noch die Eigenschaft besitzen, im kürzerwelligen sichtbaren Spektralbereich möglichst weitgehend ohne nennenswerte Absorption sowie thermisch sehr stabil zu sein, um beispielsweise durch Vakuumverdampfungsprozesse für den jeweiligen Anwendungszweck applizierbar zu sein.

Bisher sind bereits zahlreiche Verbindungstypen bekannt geworden, die neben einer intensiven Lichtabsorption im roten sowie infraroten Spektralbereich auch noch verschiedene andere, für ihren jeweiligen Einsatzzweck bestimmende Eigenschaftsmerkmale besitzen. Meist jedoch kann das Spektrum der gewünschten Eigenschaftsmerkmale nicht von einem bestimmten Verbindungstyp allein erfüllt werden. So besitzen beispielsweise Polymethinfarbstoffe, die zumeist bei ausreichender Länge der in ihnen enthaltenen Polymethinkette eine hinreichend intensive Lichtabsorption im roten und infraroten Spektralbereich besitzen, eine sehr geringe thermische Stabilität, die, bedingt durch ihre zumeist ionische Natur, einer unzersetzten Verdampfbarkeit im Wege steht. Ähnliches gilt auch für die Oxydationsprodukte von aromatischen oder heteroaromatischen Di- und Polyaminen, etwa vom Typ der 4,4',4",4"'-Tetrakis-(diarylamino)-N,N-tetraphenyl-benzidine und ihren Arylen-Homologen, die in ihrem oxydierten Zustand zwar sehr langwellige Lichtabsorptionen besitzen, aufgrund ihrer ionischen Natur aber ebenso unverdampfbar und für viele Anwendungszwecke dadurch ungeeignet sind. Im Gegensatz dazu sind Nickeldithiolen-Komplexe, die ebenfalls sehr langwellige Absorptionen im infraroten Spektralbereich besitzen, durch eine hinreichende thermische Stabilität meist gut verdampfbar, doch ist ihr Lichtabsorptionsvermögen im langwelligen Spektralbereich oft recht gering, so dass sie, um mit diesen Verbindungen hohe Absorptionsquerschnitte im IR-Spektralgebiet erreichen zu können, in hohen Konzentrationen bzw. Schichtdicken eingesetzt werden müssen, die dann aber meist dazu führen, dass störende Absorptionen im sichtbaren Spektralgebiet in Erscheinung treten.

Das einzige bisher bekannte Material für organische Solarzellen mit einer Absorption über 700nm sind Verbindungen aus der Reihe der Phthalocyanine. Diese Verbindungen zeichnen sich zwar durch eine intensive langwellige Absorption und eine hohe Stabilität aus, jedoch können diese Verbindungen aufgrund ihrer geringen Löslichkeit gar nicht oder nur schwer im Hinblick auf andere Eigenschaften wie die energetische Lage der Grenzorbitale optimiert werden.

Es ist daher eine Aufgabe der vorliegenden Erfindung, halbleitende Bauelemente bereitzustellen, die organische Verbindungen mit intensiven Absorptionen im roten und infratroten Spektralbereich enthalten, die die Nachteile des Stands der Technik überwinden und insbesondere zur Herstellung des Bauelements unzersetzt verdampfbar sind, also eine gute thermische Stabilität zeigen und im Langwellenbereich Licht absorbieren können.

Diese Aufgabe wird gelöst durch ein halbleitendes Bauelement, das mehrere Schichten umfasst, wobei zumindest eine der Schichten zumindest eine Verbindung der allgemeinen Formel **A, B** oder **C** umfasst: 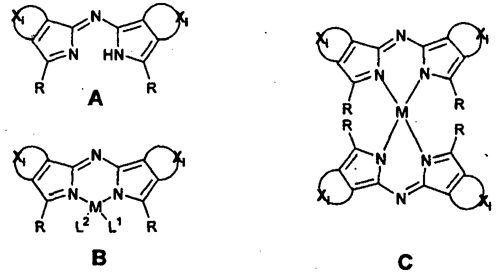 wobei M ein Metall-Ion ist, dessen Ladung vorzugsweise so bemessen ist, dass elektroneutrale Komplexe des Typs **B** bzw. C resultieren; jedes R unabhängig ausgewählt ist aus unsubstituiertem oder substituiertem C₁-C₂₀-Alkyl, C₁-C₂₀-Heteroalkyl, C₆-C₂₀-Aryl, C₆-C₂₀-Heteroaryl, gesättigtem oder ungesättigtem Carbo- oder Heterocyclus; L¹ und L², die gleich oder verschieden sein können, Atom- oder Molekülgruppierungen darstellen, die die Valenzschale von M absättigen; und **-Xᵢ-**ein Molekülfragment darstellt, das mit der angrenzenden C-C-Doppelbindung des Pyrrolrings ein aromatisches oder heteroaromatisches Strukturelement ausbildet.

Dabei ist besonders bevorzugt, dass das Bauelement ausgewählt ist aus einer organischen Solarzelle, einem Fotodetektor oder einem organischen Feldeffekttransistor. Lichtemittierende Dioden sollen nicht unter die erfindungsgemäß beanspruchten halbleitenden Bauelemente fallen, jedoch allgemein organisch-anorganische Hybridhalbleiter.

Bevorzugt wird vorgeschlagen, dass das Metall-Ion M ausgewählt ist aus Ionen der Elemente der 9. bis 13. Gruppe des Periodensystems der Elemente, vorzugsweise Cu, Zn, Ni, B oder Al.

Eine vorteilhafte Ausführungsform zeichnet sich dadurch aus, dass Xᵢ jeweils unabhängig ausgewählt ist aus 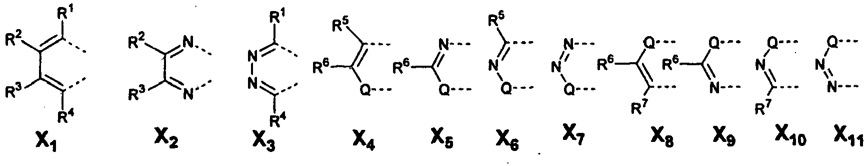 wobei R¹-R⁷ unabhängig ausgewählt sind aus Wasserstoff, Halogen, unsubstituiertem oder substituiertem C₁-C₂₀-Alkyl, C₁-C₂₀-Heteroalkyl, C₆-C₂₀-Aryl, C₆-C₂₀-Heteroaryl, gesättigtem oder ungesättigtem Carbo- oder Heterocyclus, oder wobei zwei benachbarte Reste R¹-R⁶ Bestandteil eines weiteren carbocyclischen oder heterocyclischen Rings sind; und wobei Q für eine zweibindige, die Elemente C, N, O oder S enthaltende Atomgruppierung steht.

Q kann beispielsweise -CH₂-, -NH-, -O- oder -S- sein.

Bevorzugt ist ferner, dass L¹ und L² unabhängig ausgewählt sind aus Halogen, Alkyl, Aryl, Alkyloxy, Aryloxy, Acyl, Aroyl, Alkenyl oder Alkinyl, oder L¹ und/oder L² können jeweils an ein R angebunden sein.

Sind L¹ und/oder L² an Reste R angebunden, kann dadurch ein weiterer Ring über die Verknüpfung M-L-R ausgebildet werden. Dies kann beispielsweise in Form von M-O-R einer Etherbrücke oder M-S-R einer Thioetherbrücke erfolgen.

Auch wird bevorzugt vorgesehen, dass die zumindest eine die Verbindung der Formel **A, B** oder C umfassende Schicht eine Lichtabsorberschicht oder Ladungsträgertransportschicht ist.

Ferner ist bevorzugt, dass das Bauelement fotoaktiv ist.

Eine Ausführungsform zeichnet sich dadurch aus, dass die mehreren Schichten in pin-Struktur aufgebaut sind.

Schließlich ist auch bevorzugt, dass das halbleitende Bauelement ein organisches halbleitendes Bauelement ist.

Die Erfindung betrifft ferner die Verwendung einer Verbindung der allgemeinen Formel **A, B,** oder **C** 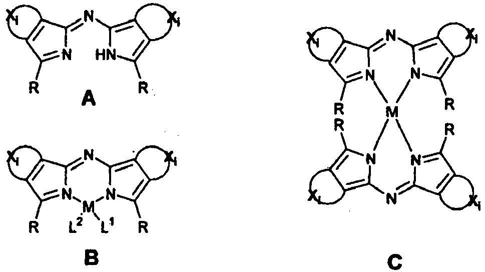 wobei M ein Metall-Ion ist, dessen Ladung vorzugsweise so bemessen ist, dass elektroneutrale Komplexe des Typ B bzw. C resultieren; jedes R unabhängig ausgewählt ist aus unsubstituiertem oder substituiertem C₁-C₂₀-Alkyl, C₁-C₂₀-Heteroalkyl, C₆-C₂₀-Aryl, C₆-C₂₀-Heteroaryl, gesättigtem oder ungesättigtem Carbo- oder Heterocyclus; L¹ und L², die gleich oder verschieden sein können, Atom- oder Molekülgruppierungen darstellen, die die Valenzschale von M absättigen; und -Xᵢ- ein Molekülfragment darstellt, das mit der angrenzenden C-C-Doppelbindung des Pyrrolrings ein aromatisches oder heteroaromatisches Strukturelement ausbildet, in einem halbleitenden Bauelement.

Die Rest R¹-R⁷ und R können bevorzugt ausgewählt sein aus Alkyl, Alkoxy, Dialkylamin, Alkylsulfanyl, Alkylsulfenyl, Alkylsulfonyl, Phenyl, Naphthyl, Anthryl, Fluorenyl, Aryloxy, Arylsulfanyl, Arylsulfenyl, Arylsulfonyl, Arylalkylamin, Diarylamin, Pyrrolidin, Tetrahydrofuran, Tetrahydrothiophen, Piperidin, Tetrahydropyran, Tetrahydrothiopyran, Pyrrol, Furan, Thiophen, Pyridin, Pyryliumion, Thiopyryliumion, Chinolin, Purin, Oxazol, Thiazol, Benzothiazol, Pyrazin, Imidazol, Pteridin, Acridin, Pyrimidin und Indol. Auch ist denkbar, dass benachbarte Reste Bestandteile eines weiteren carbocyclischen oder heterocyclischen Rings sind.

Die Verbindungen des Formeltyps **A** - **C** können auf verschiedenen Wegen, so vorzugsweise aus den an sich bekannten Verbindungen des allgemeinen Formeltyps 2, 4 oder 8 (siehe unten), in denen die Symbole X und R die vorgenannte Bedeutung haben, hergestellt werden, indem diese mit dem Ammoniumsalz einer vorzugsweise organischen Säure, wie Ameisen- oder Essigsäure, in einem hochsiedenden dipolaren Lösungsmittel (Solv), wie einem prim. oder sec. Alkanol mit einem Siedepunkt über 150°C, einem aliphatischen Carbonsäureamid, wie Formamid, DMF oder Dimethylacetamid, oder aber auch in einem mehrwertigen Alkanol vom Typ der 1,2-, 1,3-Diole oder 1,2,3-Triole, erhitzt werden, wodurch sich in meist glatter Reaktion, wie von V. F. Donyagina, S. Shimizu, N. Kobayashi und E. A. Lukyanets in Tetrahedron Lett. 2008, 49, 6152 beispielhaft beschrieben, zunächst die an ihrer tiefen Farbe erkennbaren Verbindungen das allgemeinen Formeltyps **A** bilden, die dann anschließend nach ihrer Isolierung erforderlichenfalls durch Erhitzen mit einer Verbindung der allgemeinen Formel ML¹L²L³, in der L¹ und L² die gleiche Bedeutung haben wie oben angegeben und L³ ein mit L¹ und L² identischer oder von diesen verschiedener Ligand ist, der ebenso wie L¹ und L² mit dem Atom M eine stabile Koordinationssphäre ausbilden kann, in einem polaren Lösungsmittel, wie einem niederen oder höheren Alkanol, einem aliphatischen Carbonsäureamid, wie Formamid, DMF oder Dimethylacetamid, einem Carbonsäureanhydrid, wie Essigsäure- oder Propionsäureanhydrid, Methylenchlorid oder 1,2-Dichloethan, zu den Zielverbindungen des Formeltyps **B** oder **C** umgesetzt werden.

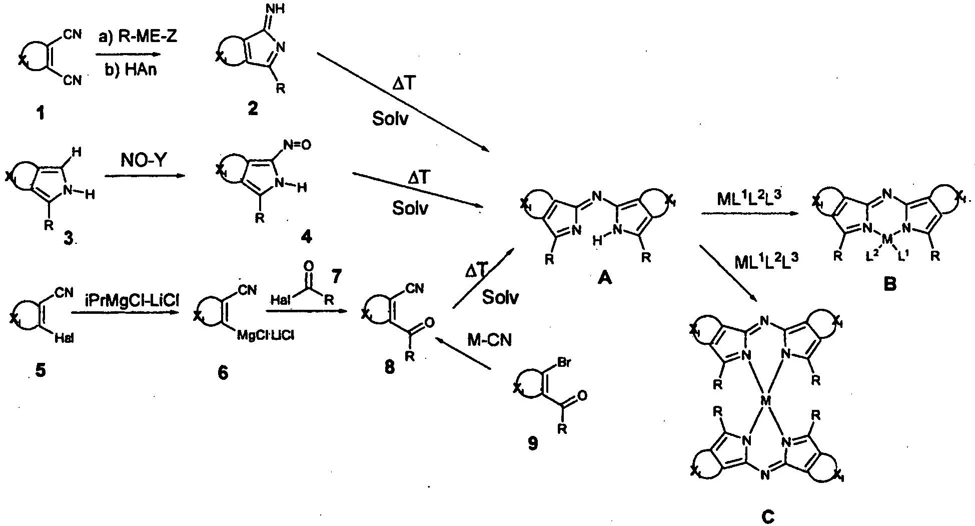

Bezüglich der vorgenannten Verbindungen des Formeltyps **2, 4** oder **8** können die Verbindungen des Typs 2 dadurch gewonnen werden, dass Verbindungen des Formeltyps 1, wie von H. Bredereck und H. W. Vollmann in Chem. Ber. 1972, 105,2271 beschrieben, mit einer metallorganischen Verbindung des allgemeinen Formeltyps R-MZₙ, in denen der Rest R die gleiche Bedeutung hat wie in Formel **A,** n entweder 0 oder 1 ist und M für ein Metall-Ion aus vorzugsweise der 1. oder 2. Gruppe des Periodischen Systems steht, wobei im letztgenannten Fall n = 1 ist und somit dieses Metall-Ion noch mit einem geeigneten, die Valenz von M absättigenden Rest Z, wie vorzugsweise ein Halogenatom, verbunden sein kann, umgesetzt werden, die Verbindungen des Formeltyps **4** dadurch, dass Verbindungen des Formeltyps 3, wie von M. A. T. Rogers in J. Chem. Soc. 1943, 590 beschrieben, mit einem Nitrosierungsreagenz NO-Y, wie mit z.B. Natriumnitrit in mineralsaurer Lösung oder mit Salpetrigsäurealkylestern in alkoholisch/mineralsaurer Lösung, zur Reaktion gebracht werden, und die Verbindungen des Formeltyps **8** dadurch, dass entweder Verbindungen des Formeltyps **5** mit Isopropylmagnesiumchlorid, wie beispielsweise von A. Krasovskiy und P. Knochel in Angew, Chem. Int. Ed. 2004, 43, 3333 beschrieben, zunächst zu Verbindungen des Formeltyps **6** umgesetzt werden und diese dann, wie etwa von R. J. Kloetzing, A. Krasovsky, und P. Knochel in Chem. Eur. J. 2007, 215 beschrieben, durch Reaktion mit einer Verbindung des allgemeinen Formeltyps **7** oder Verbindungen des allgemeinen Formeltyps **9** mit Metallcyaniden, wie beispielsweise von K. Kobayashi et al. in Bull. Chem. Soc. Japan 2006, 79, 1126 beschrieben, umgesetzt werden.

Überraschenderweise wurde festgestellt, dass die erfindungsgemäßen halbleitenden Bauelemente die im Stand der Technik aufgefundenen Nachteile nicht aufweisen, insbesondere durch die Verwendung der Verbindungen des Typs **A-C** in einem ausgezeichneten Spektralbereich aktiv sind und hohe thermische Stabilität zeigen.

Die Verbindungen **A, B** und **C** besitzen halbleitende Eigenschaften, welche bisher aus dem Stand der Technik nicht bekannt waren. Dies bedeutet, dass eine Schicht, die ausschließlich aus Material der Verbindungen **A, B** und/oder C gefertigt ist, ohne Zusätze oder weitere chemische Veränderungen bereits halbleitende Eigenschaften aufweist. Gemäß den erfindungsgemäßen Bauelementen werden dort die Verbindungen A, B und/oder C als halbleitende Schichten und nicht als Dotanden verwendet. Eine Dotierung wird dabei so verstanden, dass wenige einzelne Moleküle (Dotand) in eine Schicht (Matrix) eingebaut werden, um dort Ladungen aufzunehmen oder abzugeben und die halbleitenden Eigenschaften der Schicht (Matrix) zu verändern.

Erfindungsgemäß wird das halbleitende Bauelement aus verschiedenen Materialschichten, die unterschiedliche Funktionen erfüllen, aufgebaut, indem die Materialien nacheinander auf die vorherige Schicht aufgedampft werden. In diesem Zusammenhang bedeutet eine geschlossene Schicht, dass die vorherige Schicht komplett bedeckt ist. Dies hat zur Folge, dass Ladungsträger in dieser Schicht (bzw. durch diese Schicht) transportiert werden müssen. Folglich müssen diese Schichten halbleitende Fähigkeiten aufweisen und eine hohe Beweglichkeit von Ladungsträgern ermöglichen. Beide Eigenschaften muss ein Dotand nicht erfüllen.

Die Kombination der Absorptionseigenschaften und der elektrischen Eigenschaften der Verbindungen **A, B** und **C** führen in überraschender Weise zu einem organischen, vorzugsweise photoaktiven, Bauelement, das aus dem Stand der Technik bislang nicht bekannt war und äußerst zufrieden stellende Gesamteigenschaften, wie ausgezeichnete Aktivität im gewünschten Spektralbereich sowie hohe thermische Stabilität, zeigt.

Bevorzugt sind erfindungsgemäß halbleitenden Bauelemente, in denen die Schichten, die zumindest eine Verbindung der allgemeinen Formel **A, B** oder **C** umfassen, geschlossene Schichten oder Schichten mit interpenetrierenden Netzwerken sind. Wie bereits oben ausgeführt, bedeutet eine geschlossene Schicht, dass die vorherige Schicht komplett durch diese abgedeckt ist. Unter einer Schicht mit interpenetrierendem Netzwerk soll eine Schicht verstanden werden, in der sich Komponenten der Schicht gegenseitig durchdringen. Dies kann beispielsweise durch Co-Verdampfung zweier Materialien erreicht werden, die sich dann in einer Mischschicht selbst anordnen. Ein interpenetrierendes Netzwerk weist dabei geschlossene Perkolationspfade (Wanderwege für Ladungsträger) auf, die in einer Mischschicht erreicht werden, wenn das in geringerer Menge enthaltene Material mindestens in einem Mischungsverhältnis von >20 Massenprozent enthalten ist. Dies steht im Gegensatz zu einer Dotierung eines Matrixmaterials, in der der Dotand lediglich mit etwa vier Massenprozent vorliegt, so dass dort isolierte Einheiten bzw. Cluster des Dotanden in der Matrixschicht entstehen. Interpenetrierende Netzwerke mit geschlossenen Perkolationspfaden ermöglichen die Ausnutzung der guten Ladungsträgerbeweglichkeiten. Daher ist es besonders bevorzugt, erfindungsgemäße Bauelemente bereitzustellen, in denen zumindest eine Verbindung der allgemeinen Formel A, B oder C in einer geschlossenen Schicht bzw. geschlossenen Perkolationspfaden innerhalb einer Mischschicht vorliegt.

Die in der Regel thermisch bis meist deutlich über 300 °C stabilen und daher im Hochvakuum unterhalb dieser Temperatur unzersetzt verdampfbaren Verbindungen des Formeltyps **A - C** können auf verschiedene Weise in einem Bauelement eingesetzt werden, so vorzugsweise aufgrund ihrer langwelligen Lichtabsorption im roten oder nahen infraroten Spektralgebiet als Lichtabsorber in organischen Solarzellen oder aufgrund ihrer hohen Redoxstabilität als Ladungsgenerations- oder Ladungstransportmaterial in organischen Solarzellen sowie organischen Feldeffekt-Transistoren. Hierzu werden die genannten Verbindungen auf ein geeignetes Substrat aufgebracht, das wie beispielhaft nachfolgend beschrieben aufgebaut ist, indem sie in einer Vakuumkammer bei Drücken um 10⁻⁷ Torr aus einem Behälter so verdampft werden, dass keine Substanzzersetzung eintritt und eine mit definierter Dicke entstehende Aufdampfschicht erzeugt wird, die sich erforderlichenfalls im Verband mit weiteren Schichten befindet, von denen jede eine bestimmte elektronische Funktion besitzt.

Ein besonderer Vorzug der Verbindungen **A - C** als photoaktive Schichten in organischen Solarzellen besteht darin, dass diese aufgrund der langwelligen Absorption des eingesetzten Lichtabsorbers eine erhöhte spektrale Sensibilität im langwelligen Spektralbereich zeigen. So kann der in elektrische Energie umgewandelte Anteil der Lichtenergie auf einen Bereich über 600nm, bevorzugt aber auf einen über 700nm und besonders bevorzugt auf über 800nm erweitert werden.

Als wichtige Kenngröße bei photovoltaischen Halbleitern, wie Bauelementen, dient die Leerlaufspannung, die durch die Verwendung der oben genannten Verbindungen hohe Werte erreichen kann. Sie ergibt sich aus der relativen Lage der Energieniveaus des Donator- und des Akzeptor-Materials, deren Energieniveaus erforderlichenfalls durch geeignete elektronenziehende bzw. elektronenschiebende Gruppen so variiert werden können, dass sich der Energieverlust beim Elektronentransfer verringert und die Leerlaufspannung erhöht wird: Zusätzlich zu den bisherigen Vorteilen bei der Verwendung oben genannter Verbindungen in Solarzellen weisen solche Halbleiter einen besonders hohen Füllfaktor auf, der im konkreten Fall der Verbindung B1 (siehe unten) bei 64.89% liegt. Dieser ist gegeben durch den Quotienten aus der maximalen Leistung und dem Produkt aus Leerlauf- und Kurzschlussstrom und beschreibt damit die "Rechteckigkeit" der Strom-Spannungs-Charakteristik als ein Maß für die Güte einer Solarzelle.

Von besonderem Vorteil bei der Erhöhung der Effizienz von Halbleitern, wie Bauelementen, ist der so genannte pin-Aufbau. Hierbei werden die intrinsischen, aktiven Schichten zwischen dotierten Schichten aus organischen Halbleitern eingebracht, die bevorzugt eine große Bandlücke vorweisen und daher transparent sind. Die p-dotierte Schicht folgt auf das Donatormaterial und besitzt eine auf die HOMO-Energie des Donators angepasste HOMO-Energie. Die n-dotierte Schicht folgt auf das Akzeptormaterial und besitzt eine auf die LUMO-Energie des Akzeptormaterials angepasste LUMO-Energie. Diese Schichten besitzen aufgrund ihrer Dotierung eine sehr gute Leitfähigkeit und führen zu mehreren Verbesserungen. Die Anpassung der Energien führt dazu, dass die n-dotierte Schichten bevorzugt angeregte Elektronen transportieren und p-dotierte Schichten bevorzugt angeregte Löcher transportieren. Sie werden daher auch als Elektronen- bzw. Löcher-Transportschichten bezeichnet (ETL bzw. HTL). Dies führt in einem pin-Aufbau zur Unterstützung der, besonders in photoaktiven Halbleitern wie z.B. Solarzellen notwendigen, Trennung der Ladungsträger. Die hohe Leitfähigkeit der Schichten führt zu einer Verringerung der Injektionsbarriere für Ladungsträger am Kontakt, die sonst ein Verlustmechanismus darstellen würde. Werden als ETL bzw. HTL transparente Materialien verwendet, können diese Schichten verwendet werden, um die aktiven, absorbierenden Schichten an den Ort des optischen Maximums des einfallenden Lichtes zu schieben, um damit die Menge des in der aktiven Schicht absorbierten Lichts und damit die Effizienz des Halbleiters (Bauelement) zu erhöhen. (Maennig et al., Appl. Phys. A79, 1-14(2004*)*)

Unabhängig von den Absorptionseigenschaften der Verbindungen **A - C** erschließt sich durch ihre guten Ladungsträgertransporteigenschaften ein weiteres Anwendungsgebiet in der Verwendung für Feldeffekttransistoren. In diesen Bauteilen werden oben genannte Verbindungen A-C zwischen zwei als Emitter (Source) und Kollektor (Drain) bezeichnete Elektroden verbracht. Das organische Halbleitermaterial kann dabei noch mit geeigneten anderen Verbindungen dotiert werden, um die Anzahl der elektrischen Ladungsträger zu erhöhen. Diese können sowohl n- als auch p-Dotanden sein. Durch ein isolierendes Material von dem organischen Halbleitermaterial getrennt, befindet sich eine dritte Basis-Elektrode (Gate). Diese kann sich entweder oberhalb (Top-Gate-Anordnung) oder unterhalb (Bottom-Gate-Anordnung) von dem halbleitenden Material befinden. Durch Anlegen einer Steuerspannung zwischen Source- und Gate-Elektrode kann nun der Stromfluss zwischen beiden Elektroden gezielt gesteuert werden. Dies geschieht dadurch, dass sich durch das angelegte elektrische Feld die durch die Dotierung erzeugten Ladungsträger im organischen Halbleitermaterial nahe der Isolatorschicht anreichern. Dadurch wird der Eigenwiderstand der organischen Halbleiterschicht in diesem Bereich abgesenkt, wodurch ein Stromfluss zwischen der Source- und Drain-Elektrode möglich wird.

Weitere Vorteile und Merkmale des erfindungsgemäßen halbleitenden Bauelements ergeben sich aus der folgenden detaillierten Beschreibung bevorzugter Ausführungsformen unter Bezugnahme auf die beigefügten Zeichnungen, in denen
Figur 1 ein Absorptionsspektrum der Verbindung **A1** in Dichlormethan zeigt;
Figur 2 ein Cyclovoltammogram der Verbindung **A1** in Dichlormethan mit Ferrocen als internem Standard und Tetrabutylammonium-hexafluorophosphat (1mMol) als Leitsalz bei einer Scangeschwindigkeit von 100 mV/s bei 25°C zeigt;
Figur 3 ein Absorptionsspektrum der Verbindung **A2** in Dichlormethan zeigt;
Figur 4 ein Cyclovoltammogram der Verbindung **A2** in Dichlormethan mit Ferrocen als internem Standard und Tetrabutylammonium-hexafluorophosphat (1mMol) als Leitsalz bei einer Scangeschwindigkeit von 100 mV/s bei 25°C zeigt;
Figur 5 ein Absorptionsspektrum der Verbindung **B1** in Dichlormethan zeigt;
Figur 6 ein Cyclovoltammogram der Verbindung **B1** in Dichlormethan mit Ferrocen als internem Standard und Tetrabutylammonium-hexafluorophosphat (1mMol) als Leitsalz bei einer Scangeschwindigkeit von 100 mV/s bei 25°C zeigt;
Figur 7 ein Absorptionsspektrum der Verbindung **B2** in Dichlormethan zeigt;
Figur 8 ein Cyclovoltammogram der Verbindung **B2** in Dichlormethan mit Ferrocen als internem Standard und Tetrabutylammonium-hexafluorophosphat (1mMol) als Leitsalz bei einer Scangeschwindigkeit von 100 mV/s bei 25°C zeigt;
Figur 9a Schichtaufbauten unterschiedlicher Ausführungsformen des erfindungsgemäßen Bauelements zeigt;
Figur 9b Schichtaufbauten unterschiedlicher Ausführungsformen des erfindungsgemäßen Bauelements zeigt;
Figur 10 eine Strom-Spannungs-Charakteristik einen Beispiel 1 beschriebenen Solarzelle mit Verbindung B1 und C₆₀ als fotoaktive Schicht zeigt;
Figur 11 einen Graphen der spektralen externen Quantenausbeute einer Solarzelle mit Verbindung **B1** und C₆₀ als fotoaktive Schichten zeigt; und
Figur 12 einen Schichtaufbau des in Ausführungsbeispiel 5 dargestellten Bauelements zeigt.

Zunächst werden einige Synthesebeispiele zur Herstellung der Verbindungen des Typs **A - C** angegeben.

### Synthesebeispiele

1.Herstellung von Diisoindolylazamethinen der allgemeinen Struktur **A** 1.a Synthese von (3-Phenyl-2*H*-isoindol-1-yl)-(3-phenyl-isoindol-1-yliden)-amin (**A1**)

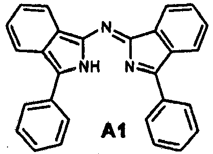

Zu einer Suspension von Phthalodinitril (12,8 g, 0,1 Mol) in Toluol (100 mL) wird unter Rühren bei Raumtemperatur eine aus Brombenzol (15,7 g, 0,1 Mol) und Magnesiumspänen (2,7 g, 0,11 Mol) nach bekannten Vorschriften hergestellte Phenylmagnesiumbromid-Lösung zugetropft und das resultierende Gemisch anschließend für 2 Stunden oder über Nacht gerührt.

Das erhaltene Reaktionsgemisch wird mit Chlortrimethylsilan (10,8 g, 0,1 Mol) versetzt und der entstandene Niederschlag abgesaugt und mit Diethylether gewaschen. Der so erhaltene Feststoff wird anschließend in Formamid (500 mL) für ca. 10 Minuten erhitzt, bis sich eine tief dunkelblaue Farbe zeigt und sich ein kupferfarbener Niederschlag bildet. Man lässt erkalten und saugt den Niederschlag ab, der anschließend mit Wasser und Methanol gewaschen wird. Die praktisch analysenreine Verbindung kann weiter durch Säulenchromatographie an Silicagel durch Elution mit Chloroform gereinigt werden.

Ausbeute: 12 g (30 mmol, 30%), rotviolette Nadeln.

Schmp. 260.7°C

¹H-NMR (500 MHz, CDCl₃): 7.32 (t, 2H, J=7.9 Hz) 7.41 (t, 2H, J=7.7 Hz), 7.47 (t, 2H, J=7.37 Hz), 7.57 (t, 4H, J=7.47 Hz), 7.96(d, 2H, J=8.0 Hz), 8.03 (d, 4H, J=7.12 Hz), 8.13 (d, 2H, J=7.89 Hz).

¹³C-NMR (125 MHz, CDCl₃): 121.31, 122.14, 126.33, 127.57, 127.74, 129.22, 129.42, 129.92, 133.18, 135.38, 143.86, 148.58.

MS (ESI): Berechnet [M+1]: 398.47. Gefunden: 398.2.

Berechnet für C₂₈H₁₉N₃: C 84.61, H 4.82, N 10.47. Gefunden: C 82.6, H 5.1, N 9.9.

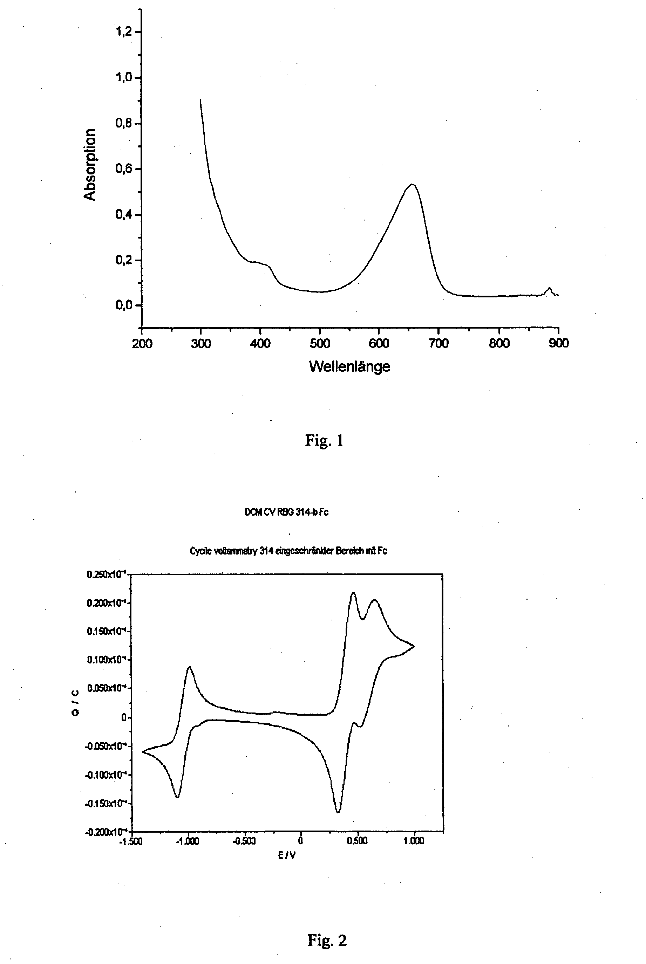

Das Absorptionsspektrum der Verbindung **A1** in Dichlormethan sowie das Cyclovoltammogram von Verbindung **A1** in Dichlormethan mit Ferrocen als internem Standard und Tetrabutylammonium-hexafluorophosphat (1mMol) als Leitsalz bei einer Scangeschwindigkeit vom 100 mV/s bei 25°C ist in Figur 1 bzw. Figur 2 gezeigt.

### 1b. Synthese von [3-(4-Methoxyphenyl)-2H-isoindol-1-yl]-[3-(4-methoxyphenyl)-isoindol-1-yliden]amin (A2)

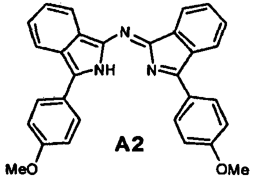

Zu einer Suspension von Phthalodinitril (12,8 g, 0,1 Mol) in Toluol (100 mL) wird unter Rühren bei Raumtemperatur eine aus p-Brombenzol (18,7 g, 0,1 Mol) und Magnesiumspänen (2,7 g, 0,1 Mol) hergestellte para-Methoxyphenyl-magnesiumbromid-Lösung zugetropft und das anfallende Gemisch anschließend für 2 Stunden oder über Nacht gerührt.

Das erhaltene Reaktionsgemisch wird mit Chlortrimethylsilan (10,8 g, 0,1 Mol) versetzt und der entstandene Niederschlag nach Absaugen mit Diethylether gewaschen. Der so erhaltene Feststoff wird anschließend in Formamid (500 mL) für ca. 10 Minuten erhitzt, bis eine tief dunkelblaue Lösung ensteht, aus der sich ein kupferfarbener Niederschlag abscheidet. Nach dem Erkalten der Lösung wird der entstandene Niederschlag abgesaugt und mit Wasser und Methanol gewaschen. Das praktisch analysenreine Produkt kann erforderlichenfalls weiter durch Säulenchromatographie an Silicagel durch Elution mit Chloroform gereinigt werden.

Ausbeute: 9,5 g (19 mmol, 19%), rotviolette Nadeln.

Schmp. 154°C

¹H-NMR (500 MHz, CDCl₃): 3.91(s, 6H), 7.08(d, 2H, J=8.85 Hz), 7.2 (t, 2H, J=7.01 Hz), 7.37 (t, 2H, J=7.03 Hz), 7.91(d, 2H, J=8.08 Hz), 7.97(d, 4H, J=8.83 Hz), 8.10(d, 2H, J=7.91 Hz).

¹³C-NMR (125 MHz, CDCl₃): 55.50, 114.73, 121.19, 122.07, 125.4, 126.04, 127.42, 129.21, 129.66, 135.30, 143.42, 147.64, 160.68.

MS (ESI): Berechnet [M+1]: 458.5. Gefunden: 458.2.

Berechnet für C₃₀H₂₃N₃O₂: C, 78.75, H 5.07, N 9.18. Gefunden: C 78.43, H 4.99, N 8.02.

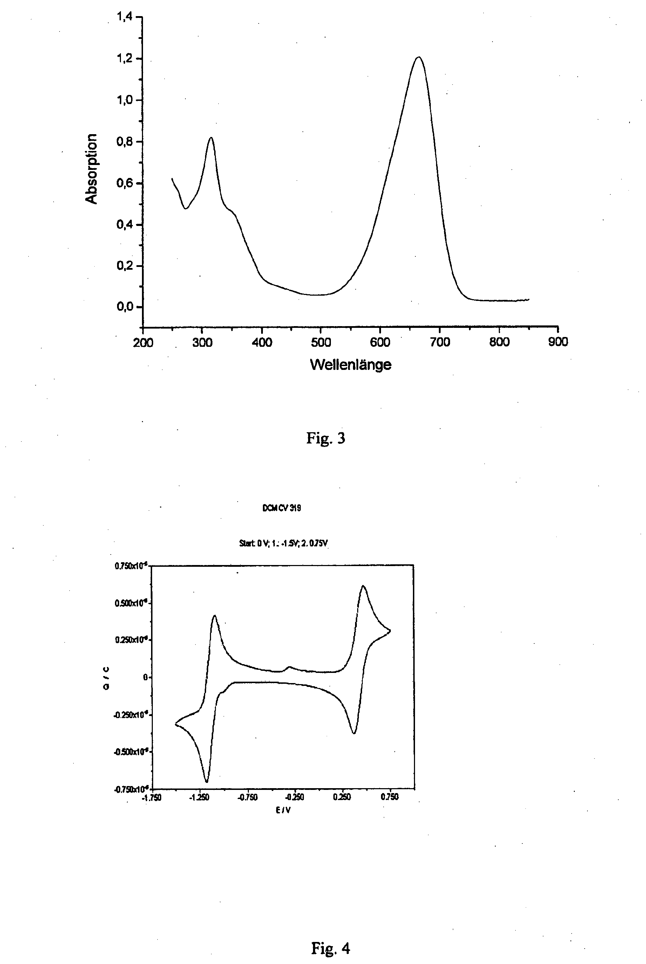

Das Absorptionsspektrum der Verbindung **A2** in Dichlormethan sowie das Cyclovoltammogram von Verbindung **A2** in Dichlormethan mit Ferrocen als internem Standard und Tetrabutylammonium-hexafluorophosphat (1mMol) als Leitsalz bei einer ScanGeschwindigkeit von 100 mV/s bei 25°C sind in Figur 3 bzw. Figur 4 gezeigt.

### 2. Herstellung von Diisoindolylazamethin-Komplexen der allgemeinen Struktur B

### 2a. Synthese von 11,11-Difluoro-10,12-diphenyl-11H-5,10a-diiaza-11a-azonium-11-boranato-indeno[2,1-b]fluoren (B1)

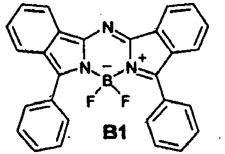

Zu einer Lösung von Verbindung **A1** (3,97 g, 10 mmol) in Dichlorethan (80 mL) werden bei Raumtemperatur zunächst mit Diisopropylethylamin (6,45 g, 50mmol) und anschließend Bortrifluorid-diethyletherat (7,05 g, 50mmol) getropft. Die so erhaltene Lösung wird erwärmt und für etwa 10 min unter Rückfluss erhitzt, bis sich die anfänglich blaue Lösung grün gefärbt hat und dünnschichtchromatographisch kein Edukt mehr nachweisbar war. Man lässt abkühlen und versetzt mit Wasser (100 mL). Die organische Phase wird dreimal mit Wasser (je 50 ml) gewaschen und das Lösemittel im Vakuum abgezogen. Der verbleibende Rückstand wird zur Reinigung in Chloroform gelöst und über Kieselgel (Chloroform) filtriert.

Ausbeute: 3,9 g (8,8 mmol, 88%), rotviolette Nadeln.

Schmp. 273°C

¹H-NMR (500 MHz, CDCl₃): 7.30 (t, 2H, J=6.98 Hz), 7.51 (m, 8H), 7.62(d, 2H, J=8.15 Hz), 7.87(d, 4H, J=7.86 Hz), 8.11 (d, 2H, J=8.00 Hz).

¹³C-NMR (125 MHz, CDCl₃): 121.19, 124.15, 127.03, 128.44, 130.16, 130.19, 130.31, 130.47, 131.14, 133.63, 139.34, 153.20.

¹⁹F-NMR (2282. MHz, CDCl₃): -129.51 (q, 2F, J=31.0 Hz)

MS (ESI): Berechnet [M+1]: 446.1. Gefunden: 446.2.

Berechnet für C₂₈H₁₈ BF₂N₃: C, 75.53, H 4.07, N 9.44. Gefunden: C 75.33, H 3.94, N 9.27.

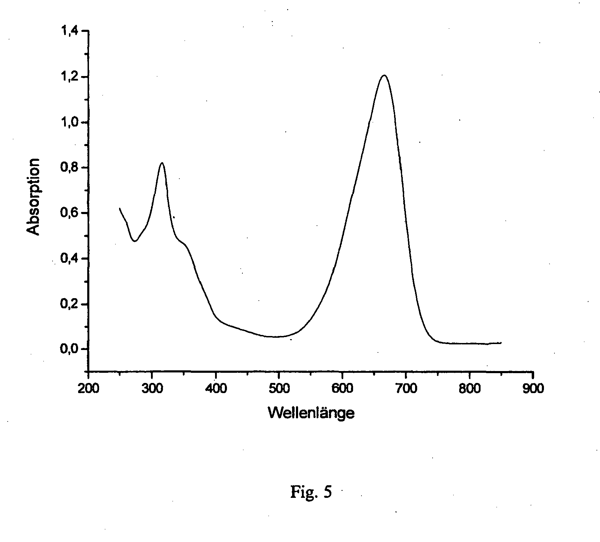

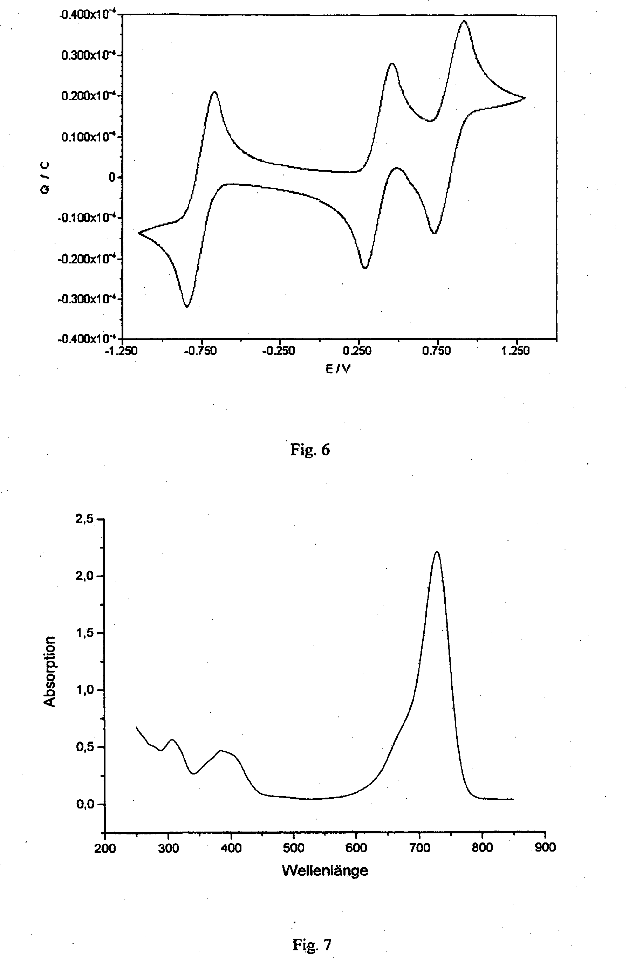

Das Absorptionsspektrum der Verbindung **B1** in Dichlormethan sowie das Cyclovoltammogram von Verbindung **B1** in Dichlormethan mit Ferrocen als internem Standard und Tetrabutylammonium-hexafluorophosphat (1mMol) als Leitsalz bei einer Scangeschwindigkeit von 100 mV/s bei 25°C sind in Figur 5 bzw. Figur 6 gezeigt.

### 2b. Synthese von 11,11-Difluoro-10,12-bis(-p-methoxyphenyl)-11H-5,11a-diaza-10a-azonium-11-boranato-indeno[2,1-b]fluoren (B2)

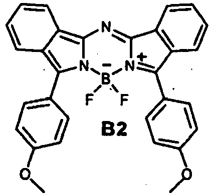

Zu einer Lösung von Verbindung **A2** (5,05 g, 10mmol) in Dichlorethan (80 mL) werden bei Raumtemperatur zunächst Diisopropylethylamin (6,45g, 50mmol) und anschließend Bortrifluorid-diethyletherat (7,05g, 50mmol) getropft. Die resultierende Lösung wird erwärmt und für etwa 10 min unter Rückfluss erhitzt, bis sich die anfänglich blaue Lösung grün gefärbt hat und diinnschichtchromatographisch kein Edukt mehr nachzuweisen ist. Man lässt abkühlen und versetzt mit Wasser (100 mL). Die organische Phase wird dreimal mit Wasser (je 50 mL) gewaschen und das Lösemittel im Vakuum abgezogen. Der Rückstand wird zur Reinigung in Chloroform gelöst und über Kieselgel filtriert.

Ausbeute: 4,1 g (8,1 mmol, 81%), kupferfarbene Nadeln.

Schmp.: 256°C.

¹H-NMR (500 MHz, CDCl₃): 3.88 (s, 6H), 7.03 (d, 4Hm, J=8.92), 7.29(t, 2H, J=7.01 Hz), 7.48 (t, 2H, J=7.15), 7.65(d, 2H, J=8.11 Hz), 7.89(d, 4H, J=8.84 Hz), 8.09(d, 2H, J=8.00 Hz).

¹³C-NMR (125 MHz, CDCl₃): 55.36, 114.10, 121.14, 122.95, 124.14, 126.81, 130.11, 131.06, 132.04, 133.51, 139.09, 152.41, 161.32.

¹⁹F-NMR (228,2 MHz, CDCl₃): -129.70 (q, 2F, J=31.0 Hz)

MS (ESI): Berechnet [M+1]: 506.3. Gefunden: 506.2.

Berechnet für C₂₈H₁₈ BF₂N₃: C ,71.31, H 4.39, N 8.32. Gefunden: C 71.14, H 4.58, N 8.22.

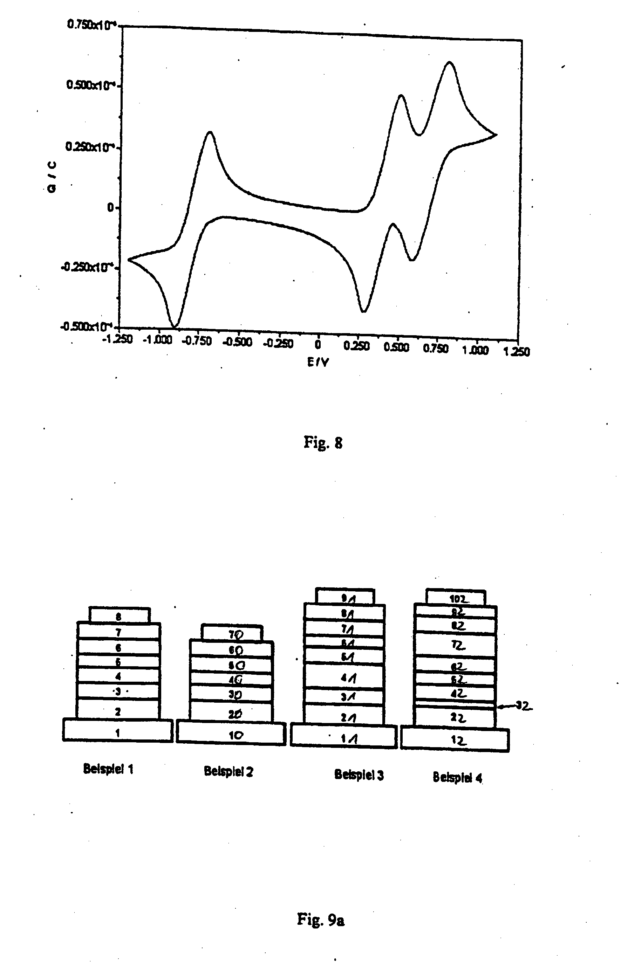

Das Absorptionsspektrum der Verbindung **B2** in Dichlormethan sowie das Cyclovoltammogram der Verbindung **B2** in Dichlormethan mit Ferrocen als internem Standard und Tetrabutylammonium-hexafluorophosphat (1mMol) als Leitsalz bei einer Scangeschwindigkeit von 100 mV/s bei 25°C gezeigt sind in Figur 7 bzw. Figur 8 gezeigt.

### 3. Herstellung von Diisoindolylazamethin-Komplexen der allgemeinen Struktur C

### 3a. Synthese von Bis-[3-(4-Methoxyphenyl)-2H-isoindol-1-yl]-[3-(4-methoxyphenyl)-isoindol-1-yliden]amin-Zink-Komplex (C1)

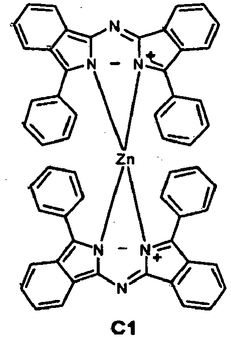

Zu einer Lösung von Verbindung **A1** (5,05 g, 10 mMol) in Dichlorethan (80 mL) wird eine Lösung von Diisopropylethylamin (6,45g, 50 mMol) und ZnCl₂ (7,0 g, 50 mMol) gegeben und anschließend für etwa 10 min unter Rückfluss erhitzt, bis sich die anfänglich blaue Lösung grün gefärbt hat und dünnschichtchromatographisch kein Edukt mehr nachzuweisen ist. Man lässt abkühlen und versetzt mit Wasser (100 mL). Die organische Phase wird dreimal mit Wasser (je 50 mL) gewaschen und das Lösemittel im Vakuum abgezogen. Der Rückstand wird zur Reinigung in Chloroform gelöst und über Kieselgel filtriert.

Ausbeute: 4,6 g (8,1 mMol, 88%), kupferfarbene Nadeln.

Zers.-Pkt. >320°C

### Ausführungsbeispiele

Unter Verwendung der beschriebenen Verbindungen des allgemeinen Formeltyps **A, B** und **C** kann eine arbeitsfähige Solarzelle aufgebaut werden. Der photoaktive Halbleiter (Bauelement), in dem die oben genannten Verbindungen verwendet werden, zeichnet sich insbesondere durch eine hohe thermische Stabilität sowie durch eine gute Photostabilität aus, wodurch eine besonders lange Lebensdauer des Bauelements erreicht wird. Die photoaktiven Schichten können dabei in Solarzellen mit MiM, Mip, Min, pin oder pii-Aufbau zum Einsatz kommen. (M=Metall, p bzw. n = p-bzw. n-dotierter, organischer oder anorganischer Halbleiter, i=intrisch-leitfähige Kombination organischer Schichten; vgl. z.B. J.Drechsel et al., Org. Electron., 5(4), 175(2004*)* oder Maennig et al., Appl. Phys. A79, 1-14(2004*)).*

Die fotoaktiven Schichten können auch in Tandemsolarzellen (vg. Peumans et al. J. Appl. Phys. 93 (7), 3693-3723 (2003*)*) oder in Tandem/Mehrfachsolarzellen aus zwei oder mehr gestapelten MiM, Mip, Min, pin oder pii-Dioden (vgl J. Drechsel et al. Thin Solid Films, 451452, 515-517 (2004*)*) verwendet werden. Dabei ist eine Mehrfach-Solarzelle aus mindestens zwei Elektroden und einem Stapel aus einer beliebigen Anzahl, mindestens jedoch zwei, Schichten aufgebaut, von denen mindestens eine Schicht Verbindungen des Typs **A - C** umfasst. Auch kann vorgesehen sein, eine weitere Schicht vorzusehen, die aus organischen und/oder anorganischen Materialien bestehen kann und als so genannter Konversionskontakt zur Rekombination von Elektronen und Löchern dient.

Ein erfindungsgemäßes fotoaktives Bauelement kann ferner Konversionskontakte aus dünnen Metallschichten, anorganischen Materialien (bspw. so genannte Nanokristalle, die aus Clustern aus Metall oder anorganischem Material mit einer Größe von weniger als 100 nm bestehen) oder organischen Materialien (bspw. dotierte oder undotierte Moleküle oder Polymere) enthalten.

Auch kann ein erfindungsgemäßes fotoaktives halbleitendes Bauelement Antidiffusionsschichten aus Metallen oder Übergangsmetallen, bspw. Titan, Palladium oder Chrom, enthalten.

Erfindungsgemäß können ebenfalls Materialien für das Bauelement vorgesehen sein, die der Verkapselung dienen, bspw. SiN oder SiO₂. Auch sind transparente Deckschichten aus organischen Materialien vorstellbar, nämlich N,N,N',N'-Tetrakis(4-methoxyphenyl)-benzidin oder Tris-(8-hydroxy-quinolinato)-aluminium, oder anorganische Materialien, wie TiO₂ oder SiO₂.

Das Bauelement gemäß der Erfindung oder Teile davon können auch in umgekehrter Reihenfolge ("invertiert") hergestellt werden, bspw. durch Austausch von Lochtransportschicht und Elektronentransportschicht oder Austausch von Top-Kontakt und Grundkontakt.

Das Bauelement kann ferner Kontakte aus dünnen Metallschichten aufweisen, die aus einem Metall oder einer Kombination aus mehreren Metallen aufgebaut sind. Eine vorteilhafte Ausführungsform der Erfindung enthält in solchen elektrischen Kontakten Elemente ausgewählt aus Aluminium, Silber, Gold, Ytterbium, Chrom, Nickel, Magnesium und Eisen.

Auch ist denkbar, dass das Bauelement Kontakte aus organischem Material aufweist, das ein leitfähiges Polymer oder eine Kombination aus mehreren organischen Materialien sein kann. Eine vorteilhafte Ausführungsform der Erfindung enthält Poly(ethylendioxythiophen):Poly(styrolsulfonat) [PEDOT:PSS].

Ebenfalls kann vorgesehen sein, dass das erfindungsgemäße Bauelement auf einem Substrat hergestellt wird, bspw. auf Glas, Holz, Aluminiumfolie, einer Metalloberfläche, wie Stahl, Kupfer, etc., textilem Materialien oder Kunststofffolie.

Auf einem solchen Substrat kann bevorzugt ein Grundkontakt aus Metall, einem leitfähigen Polymer oder einem transparenten leitfähigen Oxid oder einer Kombination derselben vorhanden sein.

Die Herstellung eines solchen erfindungsgemäßen Bauelements ist einem Fachmann auf dem Gebiet bekannt. Das Bauelement (Halbleiter) oder zumindest Teile davon können hergestellt werden durch thermisches Verdampfen oder andere thermische Verfahren, durch Rotationsbeschichtung/Aufschleudern (spincoating), Eintauchen (dip-coating), Auftropfen (dropcasting), doctor-blading, chemische Dampfphasenabscheidung (chemical vapour phase deposition, CVPD, oder organic vapour phase deposition, OVPD), Elektrodeposition oder andere chemische, elektrochemische oder nasschemische Verfahren, Siebdruck, Offset-Druck, Inkjet-Printing oder andere auf Druck basierende Verfahren, Magnetron-Sputtern oder andere, auf Kathodenzerstäubung basierende Verfahren, Molekularstrahlepitaxie oder vergleichbare Verfahren, Rolle-zu-Rolle-Verfahren (roll-to-roll) oder vergleichbare Verfahren, Auflaminieren einer Folie oder vergleichbare Verfahren, selbst-strukturierende Monoschicht-Aufbauverfahren (so genannte "self-assembled monolayers"-Verfahren) oder vergleichbare Verfahren.

Basierend auf den in Figur 9a gezeigten Schichtaufbauten wurden die folgenden beispielhaften Bauelemente hergestellt.

*Beispiel 1:* eine Probe auf Glas (1), mit transparentem Deckkontakt ITO (2), einer fotoaktiven Schicht Buckminster-Fulleren C60 (3), einer fotoaktiven Schicht aus Verbindungen des Formeltyps **A - C** (4), einer vergleichsweise dünnen undotierten Schicht PV-TPD (N,N'-di(4-(2,2-diphenyl-ethen-1-yl)-phenyl)-N,N'-di(4-methylphenylphenyl)benzidin) (5), einer dotierten Schicht PV-TPD (6), einer dotierten Schicht ZnPc(7) sowie einem Deckkontakt aus Gold(8). Die Schichten (5) bis (7) dienen der Kontaktierung der aktiven Schicht mit dem Deckkontakt.

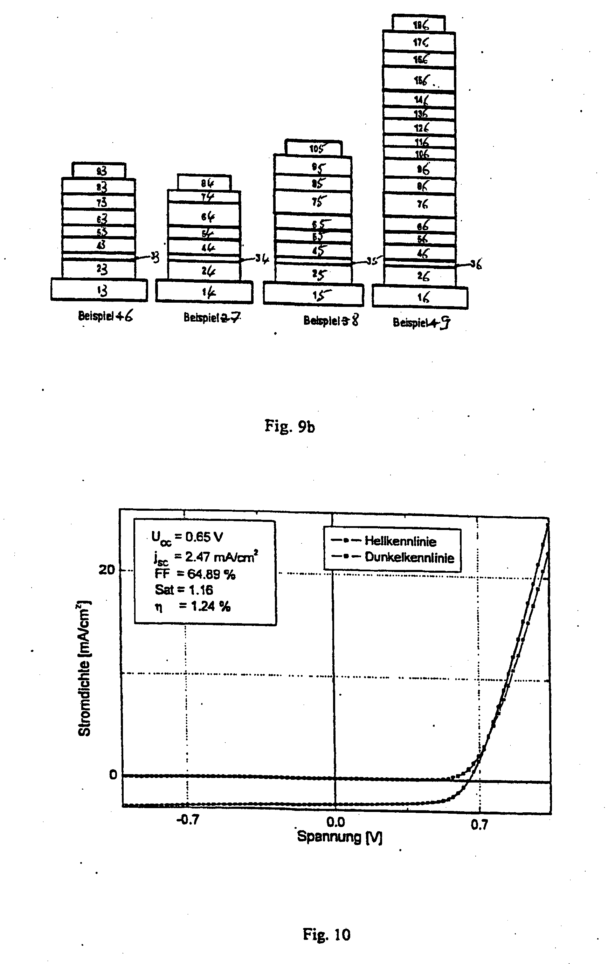

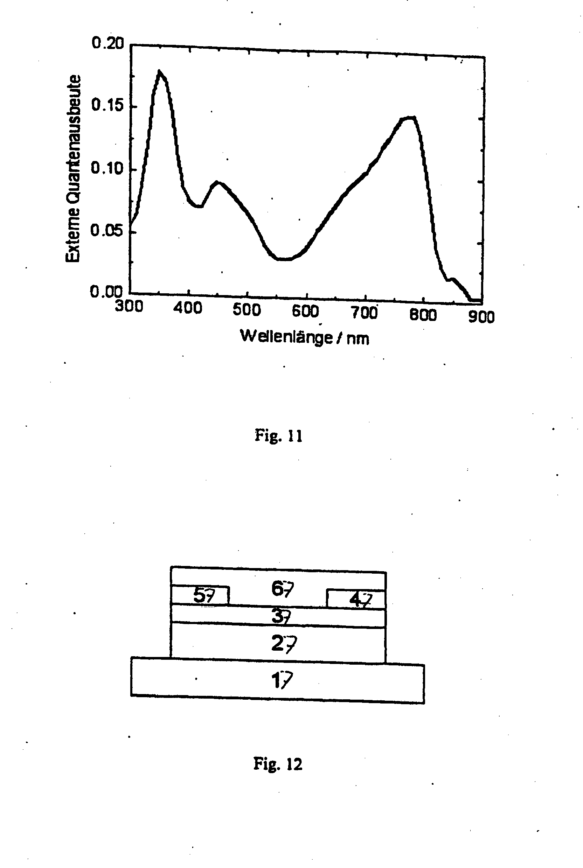

Die Stromspannungscharakteristik einer solchen Zelle ist in Fig. 10 gezeigt. Die spektrale externe Quantenausbeute, definiert als Anzahl abgeführte Elektronen pro einfallendern Photon, ist in Fig. 11 dargestellt. Sie zeigt deutlich, dass sowohl C₆₀ als auch Verbindungen des Formeltyps A-C photoaktiv sind.

Häufige Materialien die für die aktive Schicht in Kombination mit den Verbindungen **A - C** verwendet werden können, sind unter anderem Metall (Zink, Kupfer, Blei, Chlor-Aluminium, Titan, Kobalt, usw.) Phthalocyanine (ZnPc, CuPc, PbPc, ClAlPc, TiPc, CoPc), Buckminster-Fullerene (z.B. C₆₀ oder C₇₀), Dicyanovinyl-Oligothiophen-Derivative (DCVxT), Perylenderivate (PTCDA, PTCDI), Naphthalenderivate (NTCDA, NTCDI), Pentacene, Rubrene, Diindenoperylene bzw. Polymermaterialien wie [6,6]-phenyl-C₆₁-butansäuremethylester oder Poly(3-Hexylthiophene) (PCBM oder P3HT).

*Beispiel 2:* eine Probe auf Glas (10), mit transparentem Deckkontakt ITO (20), einer fotoaktiven Mischschicht aus C₆₀ und Verbindungen des Formeltyps A-C (30), einer vergleichsweise dünnen undotierten Schicht PV-TPD (40), einer dotierten Schicht PV-TPD (50), einer dotierten Schicht ZnPc(60) sowie einem Deckkontakt aus Gold(70). Die Mischschicht (40) ermöglicht eine Erhöhung des erhältlichen Stromes, da deren Schichtdicke im Gegensatz zu Einzelschichten nicht durch die Diffusionslänge der Exzitonen beschränkt ist, sondern nur durch die Bedingung, dass die erzeugten Elektronen und Löcher über zusammenhängende Pfade die Mischschicht verlassen können müssen.

*Beispiel* 3 *(Kombination aus Misch- und Einzelschichten):* eine Probe auf Glas (11), mit transparentern Deckkontakt ITO (21), einer fotoaktiven Schicht Buckminster-Fulleren C₆₀ (31), einer fotoaktiven Mischschicht aus C₆₀ und Verbindungen des Formeltyps A-C (41), einer fotoaktiven Schicht aus Verbindungen des Formeltyps A-C (51) einer vergleichsweise dünnen undotierten Schicht PV-TPD (61), einher dotierten Schicht PV-TPD (71), einer dotierten Schicht ZnPc (81) sowie einem Deckkontakt aus Gold (91). Hierbei werden Misch- und Einzelschichten kombiniert, um die mögliche Stromdichte zu maximieren

*Beispiel 4 (pii-Struktur):* eine Probe auf Glas (12), mit transparentem Deckkontakt ITO (22), einer vergleichsweise sehr dünnen Schicht Gold (32), einer dotierten Schicht PV-TPD (42), einer vergleichsweise dünnen undotierten Schicht PV-TPD (52), einer fotoaktiven Schicht aus Verbindungen des Formeltyps A-C (62), einer fotoaktiven Mischschicht aus C₆₀ und Verbindungen des Formeltyps A-C (72), einer fotoaktiven Schicht Buckminster-Fulleren C₆₀ (82), einer vergleichsweise dünnen, exzitonenblockierenden Schicht Bphen (92) sowie einem Deckkontakt aus Aluminium (102).

Ein solcher Aufbau ermöglicht somit die Gegenwart aktiver Schichten, die Photonen absorbieren und die zusammen in einer gemischten Schicht aufgetragen werden (Beispiel 4, (62) in Fig. 9a).

Auch ist es erfindungsgemäß möglich, dass das (organische) fotoaktive Bauelement Materialien enthält, die als so genannte Exzitonen-Blocker-Schicht dienen, das heißt Exzitonen daran hindern sollen, zur Elektrode zu gelangen, siehe Beispiel 4, (82). Beispiele hierfür sind: Bathocuproin (BCP), 4,7-Diphenyl-1,14-phenanthrolin (Bphen).

Häufige Lochtransportmaterialien (Fig. 9a, Beispiel 4, Ziffer 42), die mit Verbindungen des Formeltyps A-C kombiniert werden können, sind 4,4',4"-tris(1-naphthylphenylamino)-triphenylamine (TNATA), N,N'-Di(naphthalen-1-yl)-N,N'-diphenyl-benzidine (alpha-NPD), 4,4'-Bis-(N,N-diphenylamino)-quaterphenyl (4P-TP.D), N,N'-Diphenyl-N,N'-bis(4'-(N,N-bis(naphth-1-yl)-amino)-biphenyl-4-yl)-benzidine (Di-NPB), N,N,N,N'-Tetrakis(4-methoxyphenyl)-benzidine (MeO-TPD). Eine vorteilhafte Ausführung enthält in der Löchertransportschicht Materialien, die als Dotanden (Akzeptoren) dienen. Beispiel ist 2,3,5,6-Tetrafluoro-7,7,8,8-tetracyanoquinodimethan (F4-TCNQ).

Beispiele für Elektronentransportmaterialien (ETL), die mit Verbindungen des Formeltyps A-C kombiniert werden können, sind 1,4,5,8-Naphthalen-tetracarbonsäure-dianhydrid (NTCDA) oder Buckminsterfulleren (C₆₀). Eine vorteilhafte Ausführung enthält in der ETL Materialien, die als Dotanden (Donatoren) dienen. Beispiel dafür ist (N,N,N',N'-tetramethylacridin-3,6-diamin) (AOB).

Unter Verwendung der beschriebenen Verbindungen des allgemeinen Formeltyps A, B und C kann ein arbeitsfähiger (organischer) Feldeffekttransistor aufgebaut werden. Die Architektur kann dabei sowohl in Top-Gate als auch in Bottom-Gate Form ausgeführt werden.

Zusätzlich kann zur Erhöhung der Ladungsträgerkonzentration die organische halbleitende Schicht aus Verbindungen A, B und C mit geeigneten Datanden dotiert werden. Beispiele hierfür sind (F4-TCNQ) als Akzeptor bzw. (AOB) als Donator.

*Beispiel 10 (**Fig. 12**):* eine Probe auf Glas (17), Silizium (27) als Gate-Elektrode, oxidiertes Silizium als Dielektrikum mit zwei Goldelektroden (47) als Source und (57) als Drain und der halbleitenden Schicht (67) aus Verbindungen des Formeltyps A - C.

Basierend auf den in Fig. 9b gezeigten Schichtaufbauten wurden die folgenden beispielhaften Bauelemente hergestellt.

*Beispiel 6 (pin-Struktur - Einzelschichten):* eine Probe auf Glas (13), mit transparentem Deckkontakt ITO (23), einer vergleichsweise sehr dünnen Schicht Gold (33), einer dotierten Schicht PV-TPD (43), einer vergleichsweise dünnen undotierten Schicht PV-TPD (53), einer fotoaktiven Schicht aus Verbindungen des Formeltyps **A-C** (63), einer fotoaktiven Schicht Buckminster-Fulleren C₆₀ (73), einer n-dotierten Schicht C₆₀ (83) sowie einem Deckkontakt aus Aluminium (93).

*Beispiel 7 (pin-Struktur - Mischschicht):* eine Probe auf Glas (14), mit transparentem Deckkontakt ITO (24), einer vergleichsweise sehr dünnen Schicht Gold (34), einer dotierten Schicht PV-TPD (44), einer vergleichsweise dünnen undotierter Schicht PV-TPD (54), einer fotoaktiven Mischschicht aus C₆₀ und Verbindungen des Formeltyps A-C (64), einer n-dotierten Schicht C₆₀ (74) sowie einem Deckkontakt aus Aluminium (84).

*Beispiel 8 (pin-Struktur - Kombination von Misch- und Einzelschicht):* eine Probe auf Glas (15), mit transparentem Deckkontakt ITO (25), einer vergleichsweise sehr dünnen Schicht Gold (35), einer dotierten Schicht PV-TPD (45), einer vergleichsweise dünnen undotierten Schicht PV-TPD (55), einer fotoaktiven Schicht aus Verbindungen des Formeltyps A-C (65), einer fotoaktiven Mischschicht aus C₆₀ und Verbindungen des Formeltyps **A-C** (75), einer fotoaktiven Schicht Buckminster-Fulleren C₆₀ (85), einer n-dotierten Schicht C₆₀ (95) sowie einem Deckkontakt aus Aluminium (105).

*Beispiel 9 (Tandemzelle):* eine Probe auf Glas (16), mit transparentem Deckkontakt ITO (26), einer vergleichsweise sehr dünnen Schicht Gold (36), einer dotierten Schicht PV-TPD (46), einer vergleichsweise dünnen undotierten Schicht PV-TPD (56), einer fotoaktiven Schicht aus Verbindungen des Formeltyps A-C (66), einer fotoaktiven Mischschicht aus C₆₀ und Verbindungen des Formeltyps A-C (76), einer fotoaktiven Schicht Buclaninster-Fulleren C₆₀ (86), einer n-dotierten Schicht C₆₀ (56), einer vergleichsweise dünnen, vergleichsweise stark n-dotierten Schicht C60 (106), einer vergleichsweise dünnen, vergleichsweise stark p-dotierten Schicht PV-TPD (116), einer Schicht p-dotierten Schicht PV-TPD (126), einer vergleichsweise dünnen undotierten Schicht PV-TPD (136), einer fotoaktiven Schicht aus Verbindungen es Formeltyps A-C (146), einer fotoaktiven Mischschicht aus C₆₀ und Verbindungen des Formeltyps A-C (156), einer fotoaktiven Schicht Buckminster-Fulleren C₆₀ (166), einer n-dotierten Schicht C₆₀ (176) sowie einem Deckkontakt aus Aluminium (186).

Ein solcher Ausbau ermöglicht somit die Gegenwart aktiver Schichten, die Photonen absorbieren und die zusammen in einer gemischten Schicht aufgetragen werden (Beispiel 7, (54) in Fig. 9b).

Die in der vorliegenden Beschreibung, den Ansprüchen und der Zeichnung offenbarten Merkmale können sowohl einzeln als auch in beliebiger Kombination für die Verwirklichung der Erfindung in ihren unterschiedlichsten Ausführungsformen wesentlich sein.

## Patentansprüche

1. Halbleitendes Bauelement mit mehreren Schichten, wobei zumindest eine der Schichten zumindest eine Verbindung der allgemeinen Formel **A, B** oder **C** umfasst: 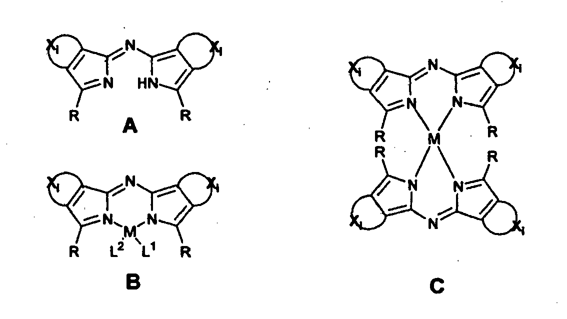 wobei M ein Metall-Ion ist, dessen Ladung vorzugsweise so bemessen ist, dass elektroneutrale Komplexe des Typ B bzw. C resultieren; jedes R unabhängig ausgewählt ist aus unsubstituiertem oder substituiertem C₁-C₂₀-Alkyl, C₁-C₂₀-Heteroalkyl, C₆-C₂₀-Aryl, C₆-C₂₀-Heteroaryl, gesättigtem oder ungesättigtem Carbo- oder Heterocyclus; L¹ und L², die gleich oder verschieden sein können, Atom- oder Molekülgruppierungen darstellen, die die Valenzschale von M absättigen; und -Xᵢ- ein Molekülfragment darstellt, das mit der angrenzenden C-C-Doppelbindung des Pyrrolrings ein aromatisches oder heteroaromatisches Strukturelement ausbildet.

2. Halbleitendes Bauelement nach Anspruch 1, **dadurch gekennzeichnet, dass** M für ein Metall-Ion steht, das ausgewählt ist aus Ionen der Elemente der 9. bis 13. Gruppe des Periodensystems der Elemente, vorzugsweise Co, Ni, Cu, Zn, Hg, B oder Al.

3. Halbleitendes Bauelement nach einem der vorangehenden Ansprüche, **dadurch gekennzeichnet, dass** Xᵢ jeweils unabhängig ausgewählt ist aus 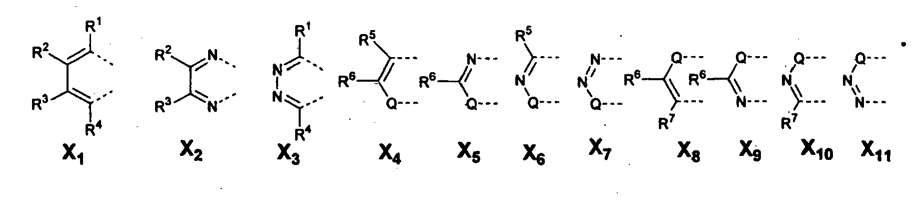 wobei R¹-R⁷ unabhängig ausgewählt sind aus Wasserstoff, Halogen, unsubstituiertem oder substituiertem C₁-C₂₀-Alkyl, C₁-C₂₀-Heteroalkyl, C₆-C₂₀-Aryl, C₆-C₂₀-Heteroaryl, gesättigtem oder ungesättigtem Carbo- oder Heterocyclus, oder wobei zwei benachbarte Reste R¹-R⁶ Bestandteile eines weiteren carbocyclischen oder heterocyclischen Rings sind; und wobei Q für eine zweibindige, die Elemente C, N, O oder S enthaltende Atomgruppierung steht.

4. Halbleitendes Bauelement nach einem der vorangehenden Ansprüche, **dadurch gekennzeichnet, dass** L¹ und L² unabhängig ausgewählt sind aus Halogen, Alkyl, Aryl, Alkyloxy, Aryloxy, Acyl, Aroyl, Alkenyl oder Alkinyl oder wobei L¹ und/oder L² jeweils an ein R gebunden ist bzw. sind.

5. Halbleitendes Bauelement nach einem der vorangehenden Ansprüche, **dadurch gekennzeichnet, dass** die zumindest eine die Verbindung der Formel **A, B** oder **C** umfassende Schicht eine Lichtabsorberschicht oder Ladungsträgertransportschicht ist.

6. Halbleitendes Bauelement nach Anspruch 5, **dadurch gekennzeichnet, dass** die Ladungsträgertransport als dotierte, teilweise dotierte oder undotierte Transportschicht ausgeführt ist.

7. Halbleitendes Bauelement nach einem der vorangehenden Ansprüche, **dadurch gekennzeichnet, dass** das Bauelement als fotoaktives Bauelement ausgeführt ist.

8. Halbleitendes Bauelement nach einem der vorangehenden Ansprüche, **dadurch gekennzeichnet, dass** die mehreren Schichten in einer pin, nip, ni, ip, pnip, pni, pip, nipn, nin, ipn, pnipn, pnin oder pipn-Struktur oder einer Kombination davon aufgebaut sind.

9. Halbleitendes Bauelement nach einem der vorangehenden Ansprüche, **dadurch gekennzeichnet, dass** es ein organisches halbleitendes Bauelement ist.

10. Halbleitendes Bauelement nach Anspruch 1, **dadurch gekennzeichnet, dass** das Bauelement ausgewählt ist aus einer organischen Solarzelle, einem Fotodetektor oder einem organischen Feldeffekttransistor.

11. Verwendung einer Verbindung der allgemeinen Formel **A, B,** oder **C** 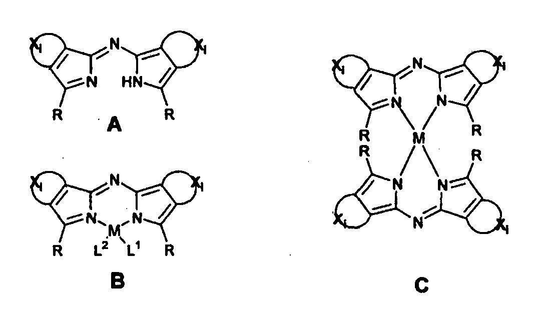 wobei M ein Metall-Ion ist, dessen Ladung vorzugsweise so bemessen ist, dass elektroneutrale Komplexe des Typ B bzw. C resultieren; jedes R unabhängig ausgewählt ist aus unsubstituiertem oder substituiertem C₁-C₂₀-Alkyl, C₁-C₂₀-Heteroalkyl, C₆-C₂₀-Aryl, C₆-C₂₀-Heteroaryl, gesättigtem oder ungesättigtem Carbo- oder Heterocyclus; L¹ und L², die gleich oder verschieden sein können, Atom- oder Molekülgruppierungen darstellen, die die Valenzschale von M absättigen; und -Xᵢ- ein Molekülfragment darstellt, das mit der angrenzenden C-C-Doppelbindung des Pyrrolrings ein aromatisches oder heteroaromatisches Strukturelement ausbildet, in einem halbleitenden Bauelement.

## Claims

1. Semiconducting component having multiple layers, wherein at least one of the layers comprises at least one compound having general formula **A, B** or **C:** 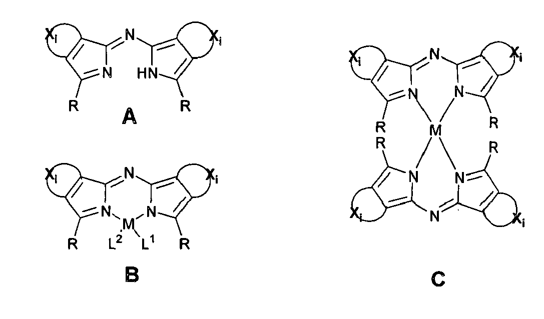 wherein M is a metal ion preferably having a charge of such magnitude that electroneutral complexes of type **B** or **C** are created; R is selected independently in each case from unsubstituted or substituted C₁-C₂₀ alkyl, C₁-C₂₀ heteroalkyl, C₆-C₂₀ aryl, C₆-C₂₀ heteroaryl, saturated or unsaturated carbo- or heterocyclic compounds; L¹ and L² may be the same or different and represent atomic or molecular assemblies that completely fill the valence shell of M; and -**Xᵢ**- represents a molecular fragment that together with the adjacent C-C double bond of the pyrrole ring forms an aromatic or heteroaromatic structure element.

2. Semiconducting component as recited in claim 1, **characterized in that** M stands for a metal ion that is selected from the ions of the elements in groups 9 to 13 of the Periodic Table, preferably Co, Ni, Cu, Zn, Hg, B or Al.

3. Semiconducting component as recited in any of the preceding claims, **characterized in that** each Xᵢ is selected independently from 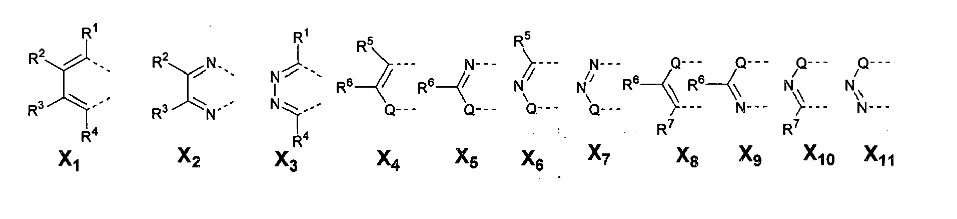 wherein R¹-R⁷ are selected independently from hydrogen, halogen, unsubstituted or substituted C₁-C₂₀ alkyl, C₁-C₂₀ heteroalkyl, C₆-C₂₀ aryl, C₆-C₂₀ heteroaryl, salt-urated or unsaturated carbo- or heterocyclic compounds, or wherein two adjacent moieties R¹-R⁶ belong to another carbocyclic or heterocyclic ring; and where Q stands for a divalent atomic assembly that contains the elements C, N, O or S.

4. Semiconducting component as recited in any of the preceding claims, **characterized in that** L¹ and L² are chosen independently from halogen, alkyl, aryl, alkyloxy, aryloxy, acyl, aroyl, alkenyl or alkinyl, or wherein L¹ and/or L² are each bound to an R.

5. Semiconducting component as recited in any of the preceding claims, **characterized in that** at least one layer comprising the compound of formula **A, B** or **C** is a is a light absorber layer or a charge carrier transport layer.

6. Semiconducting component as recited in claim 5, **characterized in that** the charge carrier transport is constructed as a doped, partially doped, or undoped transport layer.

7. Semiconducting component as recited in any of the preceding claims, **characterized in that** the component has the form of a photoactive component.

8. Semiconducting component as recited in any of the preceding claims, **characterized in that** the multiple layers are structured in a pin, nip, ni, ip, pnip, pni, pip, nipn, nin, ipn, pnipn, pnin or pipn structure, or any combination thereof.

9. Semiconducting component as recited in any of the preceding claims, **characterized in that** it is an organic semiconductor component.

10. Semiconducting component as recited in claim 1, **characterized in that** the structure element is selected from an organic solar cell, a photodetector, or an organic field effect transistor.

11. Use of a compound having general formula **A, B,** or **C** 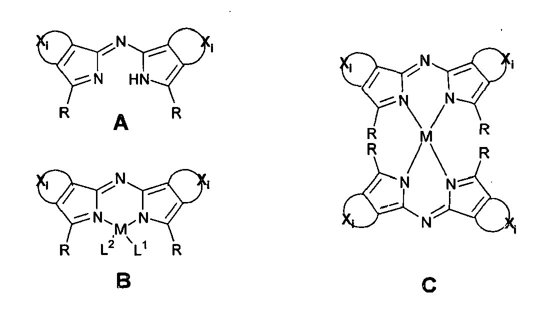 in which M is a metal ion preferably having a charge of such magnitude that electroneutral complexes of type **B** or **C** are created; R is selected independently in each case from unsubstituted or substituted C₁-C₂₀ alkyl, C₁-C₂₀ heteroalkyl, C₆-C₂₀ aryl, C₆-C₂₀ heteroaryl, saturated or unsaturated carbo- or heterocyclic compounds; L¹ and L² may be the same or different and represent atomic or molecular assemblies that completely fill the valence shell of M; and -**Xᵢ**- represents a molecular fragment that together with the adjacent C-C double bond of the pyrrole ring forms an aromatic or heteroaromatic structure element.

## Revendications

1. Composant semi-conducteur multicouche, au moins une des couches comprenant au moins un composé répondant à la formule générale **A, B** ou **C :** 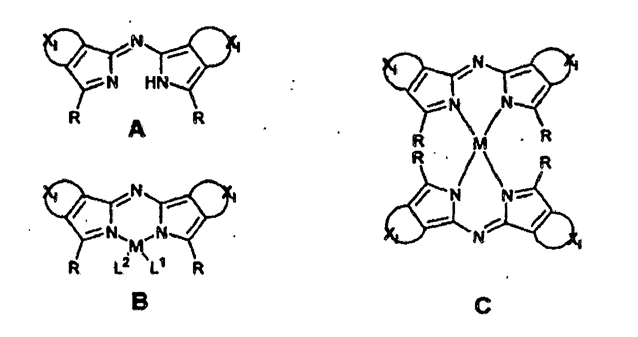 M étant un ion métallique dont la charge est préférentiellement dimensionnée telle qu'il en résulte des complexes électriquement neutres de type B ou C ; chaque R étant choisi, de façon indépendante, parmi un alkyle en C₁-C₂₀, un hétéroalkyle en C₁-C₂₀, un aryle en C₆-C₂₀, un hétéroaryle en C₆-C₂₀ lesquels peuvent être substituées ou non, un carbocycle ou un hétérocycle lesquels peuvent être saturés ou insaturés ; L¹ et L², de nature identique ou différente, représentant des groupements d'atomes ou de molécules permettant de saturer l'orbite de valence de M ; et -Xi- étant un fragment de molécule formant avec la double liaison C-C adjacente de l'anneau pyrrole un élément structural aromatique ou hétéroaromatique.

2. Composant semi-conducteur selon la revendication 1, **caractérisé en ce que** M représente un ion métallique choisi parmi les ions des éléments issus du 9^{ème} au 13^{ème} groupe du tableau périodique des éléments, s'agissant préférentiellement de Co, Ni, Cu, Zn, Hg, B ou Al.

3. Composant semi-conducteur selon l'une des revendications précédentes, **caractérisé en ce que** chaque Xᵢ est choisi, de manière indépendante, parmi 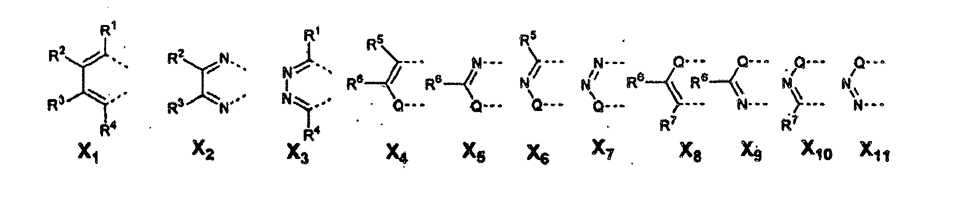 R¹ à R⁷ étant choisis, de façon indépendante, parmi l'hydrogène, un halogène, un alkyle en C₁-C₂₀, un hétéroalkyle en C₁-C_{20,} un aryle en C₆-C₂₀, un hétéroaryle en C₆-C₂₀ lesquels peuvent être substituées ou non, un carbocycle ou un hétérocycle lesquels peuvent être saturés ou insaturés, ou bien deux radicaux voisins, parmi R¹ à R⁶, faisant partie d'un autre anneau carbocyclique ou hétérocyclique ; et Q représentant un groupement d'atomes divalent qui contient les éléments C, N, O ou S.

4. Composant semi-conducteur selon l'une des revendications précédentes, **caractérisé en ce que** L¹ et L² sont choisis, de façon indépendante, parmi un halogène, un alkyle, un aryle, un alkyloxy, un aryloxy, un acyle, un aroyle, un alcényle ou un alcynyle, ou bien L¹ et/ou L² étant chacun lié à un R.

5. Composant semi-conducteur selon l'une des revendications précédentes, **caractérisé en ce que** l'au moins une couche, laquelle comprend le composé répondant à la formule **A, B** ou C, est une couche d'absorption de lumière ou une couche de transport de porteurs de charge.

6. Composant semi-conducteur selon la revendication 5, **caractérisé en ce que** la couche du transport de porteurs de charge est réalisé par une couche de transport dopée, partiellement dopée ou non dopée.

7. Composant semi-conducteur selon l'une des revendications précédentes, **caractérisé en ce que** ledit composant est réalisé sous forme d'un composant photoactif.

8. Composant semi-conducteur selon l'une des revendications précédentes, **caractérisé en ce que** lesdites plusieurs couches sont constituées d'une structure de type pin, nip, ni, ip, pnip, pni, pip, nipn, nin, ipn, pnipn, pnin ou pipn ou d'une de leurs combinaisons.

9. Composant semi-conducteur selon l'une des revendications précédentes, **caractérisé en ce que** le composant semi-conducteur est de nature organique.

10. Composant semi-conducteur selon la revendication 1, **caractérisé en ce que** ledit composant est choisi parmi une cellule solaire organique, un photodétecteur ou un transistor à effet de champ de nature organique.

11. Utilisation, dans un composant semi-conducteur, d'un composé répondant à la formule générale **A, B** ou **C,** 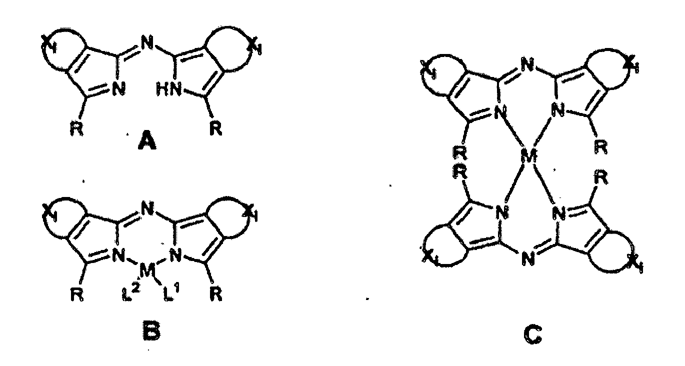 M étant un ion métallique dont la charge est préférentiellement dimensionnée telle qu'il en résulte des complexes électriquement neutres de type B ou C ; chaque R étant choisi, de façon indépendante, parmi un alkyle en C₁-C₂₀, un hétéroalkyle en C₁-C₂, un aryle en C₆-C₂₀, un hétéroaryle en C₆-C₂₀ lesquels peuvent être substituées ou non, un carbocycle ou un hétérocycle lesquels peuvent être saturés ou insaturés ; L¹ et L², de nature identique ou différente, représentant des groupements d'atomes ou de molécules permettant de saturer l'orbite de valence de M ; et -Xᵢ- étant un fragment de molécule formant avec la double liaison C-C adjacente de l'anneau pyrrole un élément structural aromatique ou hétéroaromatique.
